Europäisches Patentamt

European Patent Office

Office européen des brevets

(19)

(11) **EP 0 841 412 B1**

(12) **EUROPEAN PATENT SPECIFICATION**

(45) Date of publication and mention
of the grant of the patent:
**17.10.2001 Bulletin 2001/42**

(21) Application number: **97918418.1**

(22) Date of filing: **13.05.1997**

(51) Int Cl.[7]: **C25D 1/04**, H05K 1/09,
C25D 3/38

(86) International application number:
**PCT/JP97/01604**

(87) International publication number:
**WO 97/43466 (20.11.1997 Gazette 1997/50)**

(54) **HIGH-TENSILE ELECTROLYTIC COPPER FOIL AND PROCESS FOR PRODUCING THE SAME**

ELEKTROLYTKUPFERFOLIE MIT HOHER ZUGSPANNUNG UND VERFAHREN ZU DEREN
HERSTELLUNG

FEUILLE DE CUIVRE ELECTROLYTIQUE A RESISTANCE ELEVEE A LA TRACTION, ET
PROCEDE DE PRODUCTION ASSOCIE

(84) Designated Contracting States:
**AT BE CH DE DK ES FI FR GB GR IE IT LI LU NL
PT SE**

(30) Priority: **13.05.1996 JP 14119896**

(43) Date of publication of application:
**13.05.1998 Bulletin 1998/20**

(73) Proprietor: **Mitsui Mining and Smelting Co., Ltd
Shinagawa-ku, Tokyo (JP)**

(72) Inventors:
• **SAKAI, Hisao
Kitaadachi-gun, Saitama 362 (JP)**
• **YOKOTA, Toshiko
Ageo-shi, Saitama 362 (JP)**
• **ASAI, Tsutomu
Ageo-shi, Saitama 362 (JP)**
• **TAKAHASHI, Susumu
Kawagoe-shi, Saitama 350 (JP)**

• **SUZUKI, Mitsuo
Sakado-shi, Saitama 350-02 (JP)**
• **DOBASHI, Makoto
Ageo-shi, Saitama 362 (JP)**
• **HARA, Yasuji
Ageo-shi, Saitama 362 (JP)**

(74) Representative: **Wilhelms, Rolf E., Dr. et al
WILHELMS, KILIAN & PARTNER
Patentanwälte
Eduard-Schmid-Strasse 2
81541 München (DE)**

(56) References cited:
**JP-A- 7 054 183          JP-A- 7 188 969**

Remarks:
The file contains technical information submitted
after the application was filed and not included in this
specification

EP 0 841 412 B1

**Description**

<u>Technical Field</u>

The present invention relates to a high tensile strength electrodeposited copper foil and the production process of the same, and more particularly relates to the electrodeposited copper foil in which the tensile strength, particularly, the tensile strength of a copper foil after heating is maintained to a high level, by fining each diameter of crystalline particles on a matte surface side of a copper foil to reduce the surface roughness, and to the production process of the electrodeposited copper foil with an enhanced tensile strength of the copper foil after heating by electrolyzing an electrolyte comprising a polyether, tin ions and iron ions, and further by reducing chlorine ions. Thus obtained copper foil is preferably used for a TAB (Tape Automated Bonding) tape, and may widely be used for a copper foil for a general use.

<u>Background Art</u>

A TAB tape which is used for producing a TAB can be obtained by bonding a matte surface side of a copper foil obtained by an electrodeposited process to one side or both sides of a base material, such as polyimide. In thus produced TAB tape, a desired circuit pattern is formed on a copper foil by an etching process.

In recent TAB tapes, a high density fine patterning has increasingly been progressed, and the development of a 320 channel and 50 μm pitch TAB tape has been required as a TAB tape in the next generation.

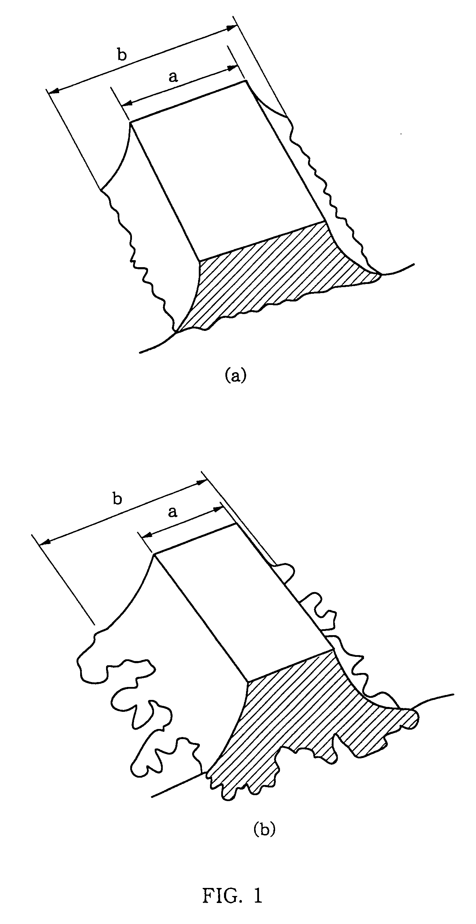

It is necessary to sufficiently assure insulating properties between the circuit patterns to cope with the requirements of this high density fine patterning. That is, it is necessary to reduce the difference between a top width and a bottom width of the circuit pattern formed by an etching process, thereby to enhance the section modulus, and also to reduce the difference between inwardly concave and outwardly convex bottom lines of a circuit pattern (see Fig. 1). In this case, if the difference between the inwardly concave and outwardly convex bottom lines of a circuit pattern is bad, the insulating properties between the circuit patterns cannot sufficiently been assured as shown in Fig. 1(b). On the other hand, if the difference therebetween is improved as shown in Fig. 1(a), the insulating properties between the circuit patterns can sufficiently been assured. Further, at the time of lamination for forming a TAB tape in which a copper foil is bonded to a base material, although the copper foil and the base material are heated to about 180°C, tensile strength of the thus heated copper foil is lowered by heating at 180°C and deformation of inner lead portions can occur in the subsequent process after the etching process. Thus, a copper foil is required, which can prevent deformation of the inner lead portion and has a large tensile strength after heating process.

However, any copper foil which has been developed to the present time as a fine pitch circuit is insufficient to cope with such requirement, with the result that the above-mentioned objects have not been attained.

Therefore, a copper foil is required, which can prevent deformation of the inner lead portion in the subsequent process after etching, by further progressing the reduction of roughness at the matte surface side of a copper foil which is a bonded surface side to a base material such as polyimide, and the fining of crystalline particles of the copper foil, to improve the difference between the inwardly concave and outwardly convex bottom lines of a circuit pattern obtained by an etching process while maintaining the peeling strength, and by enhancing the etching factor and the tensile strength of the copper foil after heating.

Electrodeposited copper foils have heretofore been produced by controlling the electrolyte composition, electrodeposited conditions and additives and the like, which copper foils have various types to match the uses. One example of values of the physical properties of a commercially available electrodeposited copper foil for a TAB tape (VLP (Very Low Profile) foil produced by Mitsui Mining & Smelting Co., Ltd.) will be described in Table 1.

Table 1

| Physical properties of commercially available copper foil (18μm) | | | | |
|---|---|---|---|---|
| room temperature | | after heating *1 | | |
| tensile strength (kgf/mm$^2$) | elongation (%) | tensile strength (kgf/mm$^2$) | elongation (%) | roughness $R_z$ (μm) |
| (50.0) | 7.0 | (48.0) | 6.0 | 3.8 |
| 490 N/mm$^2$ | | 470 N/mm$^2$ | | |

*1: after one hour oven heating at 180°C

On the other hand, in the TAB tape, as mentioned-above, development of a TAB tape which is suitable for high density fine patterning is required, and the production process for an electrodeposited copper foil, which can cope with this requirement is needed.

In a conventional technique of, for example, a fine pitch circuit copper foil, the surface state of a matte surface of a copper foil is bad and the difference between the inwardly concave and outwardly convex bottom lines of a circuit pattern is poor.

Thus, an electrodeposited copper foil is required, which can improve the difference between the inwardly concave and outwardly convex bottom lines of a circuit pattern formed by an etching process, by fining or miniaturizing crystalline particles of the electrodeposited copper foil on a matte surface side thereof which becomes a bonding surface to a base material such as polyimide or the like, to lower the surface roughness ($R_Z$), and which can prevent deformation of the inner lead in the forming process of circuit patterns and processes subsequent to the etching process and does not deteriorate adhesive properties to the pattern portions of a base material; and also, the production process of the electrodeposited copper foil is required.

Accordingly, the object of the present invention is to provide a high tensile strength electrodeposited copper foil in which crystalline particles on a matte surface side of the copper foil are fined to lower the surface roughness thereof, and the etching factor and the tensile strength are improved, in which the tensile strength exhibiting after heating is particularly improved, and provide the production process of the same.

The objects of the invention are achieved by the copper foil according to claims 1 and 2, the process according to claim 3 and the TAB (Tape Automated Bonding) tape according to claim 4.

The present inventors made intensive studies to achieve the above object and, as the result of their studies, found that the cutting quality of irregularity of the bottom lines (the difference between inwardly concave and outwardly convex bottom lines) of the circuit pattern by etching is improved by making not more than 2.5 μm in the surface roughness R of a matte surface of a copper foil containing 50-1200 ppm of Sn and 1-50 ppm of Fe and not less than 392 N/mm$^2$ (40 kgf/mm$^2$) in the tensile strength of a copper foil containing 50-1200 ppm of Sn and 1-50 ppm of Fe after one hour oven heating at 180°C, and further found that the deformation of the inner lead portions is prevented, thus completing the present invention. In addition, the present inventors found that a process for producing a high tensile strength electrodeposited copper foil can be manufactured by electrolyzing an electrolyte comprising predetermined amounts of a polyether, tin ions and iron ions and reducing chlorine ions therein.

That is, a high tensile strength electrodeposited copper foil of the present invention is characterized in that a surface roughness $R_Z$ of a matte surface side of said copper foil containing 50-1200 ppm of Sn and 1-50 ppm of Fe is not more than 2.5μm and the tensile strength of a copper foil containing 50-1200 ppm of Sn and 1-50 ppm of Fe after one hour oven heating at 180°C is not less than 392 N/mm$^2$ (40 kgf/mm$^2$). In addition, it is characterized in that the matte surface side of said copper foil containing 50-1200 ppm of Sn and 1-50 ppm of Fe is oriented disorderly. Further, a process for producing a high tensile strength electrodeposited copper foil of the present invention is characterized in that the process comprises a step of electrolyzing an electrolyte containing a copper sulfate and sulfuric acid as main components, and containing 0.01 to 0.10 g/l of a polyether, 0.5 to 1.0 g/l of tin ions, 0.5 to 5.0 g/l of iron ions and less than 0.1 mg/l of chlorine ions.

Brief Description of Drawings

Fig. 1 is a schematic view illustrating a state of the difference between inwardly concave and outwardly convex portions of bottom lines of a circuit pattern formed by an etching process.

Fig. 2 is a photograph of a surface state on a matte surface side of the electrodeposited copper foil obtained in Example 1, taken by a scanning electron microscopy (SEM).

Fig. 3 is a photograph of a surface state on a matte surface side of the electrodeposited copper foil obtained in Comparative Example 1, taken by a scanning electron microscopy (SEM).

Fig. 4 is a photograph of a 50 μm pitch circuit obtained in Example 1, taken by a scanning electron microscopy (SEM).

Fig. 5 is a photograph of a 50 μm pitch circuit obtained in Comparative Example 1, taken by a scanning electron microscopy (SEM).

Fig. 6 is a schematic view for obtaining the etching factors Ef.

Fig. 7 is a schematic view for calculating the degrees of linearity of circuits.

Fig. 8 is a view of X-ray diffraction of an electrodeposited copper foils obtained in Example 1 and Comparative Example.

Best Mode for Carrying Out the Invention

Hereunder, the high tensile strength electrodeposited copper foil according to the present invention will be described in more detail.

The surface roughness (Rz) on the matte surface side of the high tensile strength electrodeposited copper foil containing 50-1200 ppm of Sn and 1-50 ppm of Fe of the present invention is not more than 2.5 $\mu$m. If the surface roughness on the matte surface side of the copper foil is more than 2.5 $\mu$m, the cutting quality of irregularity of the bottom lines, that is, the difference between the inwardly concave and outwardly convex bottom lines of a circuit pattern formed by an etching process becomes large, which is not preferable.

The tensile strength of a copper foil containing 50-1200 ppm of Sn and 1-50 ppm of Fe after one hour oven heating at 180°C is not less than 392 N/mm$^2$ (40 kgf/mm$^2$). If the tensile strength of the copper foil, which is exhibited after heating, does not reach 392 N/mm$^2$ (40 kgf/m$^2$), deformation of the inner lead portions cannot be prevented in a process subsequent to the etching process, which is not preferable.

Thus, by lowering the surface roughness on the matte surface side of the electrodeposited copper foil containing 50-1200 ppm of Sn and 1-50 ppm of Fe to a desired value or less and enhancing the etching factors and the tensile-strength which is exhibited after one hour oven heating at 180°C, the difference between the inwardly concave and outwardly convex bottom lines of a circuit pattern formed by an etching process can be improved and deformation of the inner lead portions of the circuit pattern can be prevented. As a result, the present invention can cope with a need of a high density fine patterning TAB tape.

In the above-mentioned high tensile strength electrodeposited copper foil, it is preferable that copper crystals of the matte surface side of the copper foil are oriented disorderly in order to enhance the etching factor. That is, it is preferable that copper crystals of the matte surface side of the copper foil are oriented disorderly to X-ray diffraction strength of peeks such as (111), (200), (220) and (311) planes of the copper crystals.

The present inventors have found that by electrolyzing a chlorine ion-reduced electrolyte containing predetermined amounts of a copper sulfate and sulfuric acid as main components and containing a polyether, tin ions and iron ions respectively, each diameter of the crystalline particles on the matte surface side of the copper foil is fined, and the copper crystals are oriented disorderly, and further, the tensile strength of the obtained copper foil containing 50-1200 ppm of Sn and 1-50 ppm of Fe, which is exhibited after one hour oven heating at 180°C, can be enhanced.

If the tin (Sn) concentration in a copper foil is less than 50 ppm, the tensile strength of the copper foil, which is exhibited after heating, is undesirably reduced. On the other hand, if the Sn concentration exceeds 1200 ppm, the tensile strength of the copper foil, which is exhibited after heating, is not so much increased, and each diameter of the crystalline particles thereof becomes large, thereby producing a matte surface having a large surface roughness in the copper foil. Further, if the iron (Fe) concentration is less than 1 ppm, the crystalline particles on a matte surface side of the copper foil cannot be fined or miniaturized. On the other hand, if the Fe concentration exceeds 50 ppm, effects are not further increased.

Next, a process for producing a high tensile strength electrodeposited copper foil according to the present invention will be described in more detail.

An electrolyte which is used for producing a high tensile strength electrodeposited copper foil of the present invention, is one containing a copper sulfate (CuSO$_4$·5H$_2$O) and sulfuric acid (H$_2$SO$_4$) which are usually used, as main components. In the production process for an electrodeposited copper foil of the present invention, it is necessary to reduce the chlorine ions in the electrolyte. Therefore, the concentration of the chlorine ions is less than 0.1 mg/l. Thus, by reducing the chlorine ions, the phenomena occur that the tensile strength of an obtained copper foil increases at room temperature and the difference between the inwardly concave and outwardly convex bottom lines of a circuit pattern formed by an etching process is reduced. In 0.1 mg/l or more of the concentration of the chlorine ions, the tensile strength of a copper foil is decreased at room temperature, while the surface roughness of the matte surface of the copper foil is increased, that is, the surface thereof becomes further coarse.

Polyether which is expressed by the following structural formula

$$- (R - O)\text{-}_n$$

is contained in an electrolyte which is used for a production process for an electrodeposited copper foil of the present invention. The concentration of the polyether is 0.01 to 0.10 g/l. By allowing a polyether in this concentration range to contain in the electrolyte, the tensile strength of an obtained copper foil is increased at room temperature. If the concentration of the polyether is less than 0.01 g/l, the tensile strength of an obtained copper foil is lowered at room temperature. On the other hand, if the concentration of the polyether exceeds 0.10 g/l, while the tensile strength of an obtained copper foil is not changed at room temperature, the surface roughness $R_Z$ of a matte surface of a copper foil is undesirably more than 2.5 $\mu$m.

Further, tin ions are contained in this electrolyte. The concentration of the tin ions is 0.5 to 1.0 g/l. By allowing tin ions to be contained in this range of concentration, the tensile strength of the copper foil after heating is significantly increased. If the concentration of tin ions is less than 0.5 g/l, the tensile strength of the copper foil after heating cannot be improved. On the other hand, if the concentration thereof exceeds 1.0 g/l, the surface roughness $R_Z$ of a matte surface of an obtained copper foil is undesirably more than 2.5 $\mu$m. Although the kind of a salt of tin is not particularly limited, stannic sulfate is preferably used.

Further, iron ions are contained in this electrolyte. The concentration of iron ions are 0.5 to 5.0 g/l. By allowing iron ions to be contained in this range, the surface roughness of a matte surface of an obtained electrodeposited copper foil can be decreased. If the concentration of iron ions in the electrolyte is less than 0.5 g/l, the surface roughness of a matte surface thereof is increased. On the other hand, if the concentration thereof exceeds 5.0 g/l, while the decrease of the surface roughness is appreciated, the electric current efficiency is undesirably lowered. Although the kind of a salt of iron is not particularly limited, ferric sulfate heptahydrate is preferably used.

Ranges of each component of an electrolyte used for producing an electrodeposited copper foil of the present invention will be described below (Table 2).

Table 2

| Polyether | 0,01-0,10 g/l |
|---|---|
| Tin ions | 0,5-1,0 g/l |
| Iron ions | 0,5-5,0 g/l |
| Chlorine ions | < 0,1 mg/l |
| $CuSO_4 \cdot 5H_2O$ | preferably 283-232 g/l |
| $H_2SO_4$ | preferably 110-200 g/l |

The present invention will now be described concretely with reference to the following Examples and Comparative Examples.

Example 1

An electrolyte having a composition of 314 g/l of copper sulfate ($CuSO_4 \cdot 5H_2O$), 150 g/l of sulfuric acid ($H_2SO_4$), 0.01 g/l of polyether (polyethylene glycol having a molecular weight of about 6000), 0.5 g/l of Sn and 1 g/l of Fe was prepared. The electrolyte was electrolyzed at a current density of 40 - 65 A/dm$^2$ and at a liquid temperature of 45 - 55 °C. to produce an electrodeposited copper foil having a thickness of 18μm.

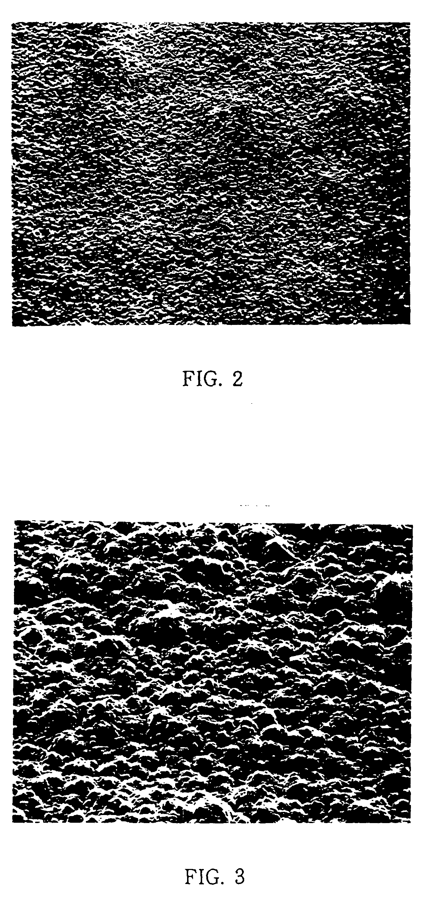

A scanning electron micrograph (SEM photograph) of the surface state of a matte surface side of the obtained electrodeposited copper foil is shown in Fig. 2. As apparent from the SEM photograph, fine concave and convex portions are formed on the surface thereof at high density.

The surface roughness $R_Z$ of the matte surface side of thus obtained electrodeposited copper foil was measured by using a surface roughness tester. The result of the measurement was 2.5 μm. On the other hand, the tensile strength of electrodeposited copper foil after heating (after one hour oven heating at 180 °C) was 403 N/mm$^2$ (41.1 kgf/mm$^2$).

Next, a roughened treatment in order to enhance adhesion strength was carried out to the matte surface side of the electrodeposited copper foil by the following methods. In the roughened treatment the three step treatments as shown below were carried out.

(1) First step treatment (nodular plating)

　　Cu : 12 g/l
　　$H_2SO_4$ : 80 g/l
　　Solution temperature : 25 °C
　　Current density : 40 A/dm$^2$
　　Time of electrolysis : 4 sec.

(2) Second step treatment (cover plating)

　　Cu : 60 g/l
　　$H_2SO_4$ : 90 g/l
　　Solution temperature : 50 °C
　　Current density : 50-60 A/dm$^2$
　　Time of electrolysis : 4 sec.

(3) Third step treatment (whiskery plating)

　　Cu : 8 g/l

$H_2SO_4$ : 80 g/l
9-phenyl acrydine : 150 mg/l
$Cl^-$ : 25 mg/l
Solution temperature : 30 °C
WE current density : 40 A/dm$^2$
Time of electrolysis : 4 sec.

The roughened surface of the copper foil thus treated was subjected successively to a rust-preventive treatment by the following conditions.

(zinc-nickel plating bath composition)

Zn : 1.5 g/l
Ni : 0.5 g/l
Pottasium pyrophosphate : 80 g/l
pH : 10.5

(plating condition)

Solution temperature : 38 °C
Current density : 40 A/dm$^2$
Time of electrolysis : 4 sec.

After the zinc-nickel plating was conducted under the above conditions, the surface thereof was washed with water and then the surface thereof was subjected to a chromate-treatment by the following conditions.

(chromate rust-preventive treatment condition)

$CrO_3$ : 0.5 g/l
pH : 11.5
Solution temperature : 30 °C
Current density : 40 A/dm$^2$
Time of electrolysis : 4 sec.

After the chromate rust-preventive treatment, the thus treated surface was immediately washed with water and then the surface thereof was coated by showering a mixture solution of a silane coupling agent and chromic acid. The composition of this solution for treatment is the following conditions.

(composition of silane coupling agent-chromic acid solution)

$CrO_3$ : 0.5 g/l
Silane coupling agent : 5 g/l
pH : 5.0

The electrodeposited copper foil obtained by applying the above roughened treatment and rust-preventive treatment was bonded onto a polyimide base material to produce a TAB tape. 50 μm pitch fine pattern circuits were formed on the obtained TAB tape, and both of the difference between the inwardly concave and outwardly convex bottom lines of a circuit pattern formed by an etching process and bending at the 50 μm pitch inner lead portions were evaluated. A measuring method of bending (flexion) at inner lead portions was carried out by observing from the side face thereof with a microscope.

According to the results of this evaluation. the difference between the inwardly concave and outwardly convex bottom lines thereof was desirably small, and the difference between the top width and bottom width of the circuit is also small while the top width thereof is large. Further the bending of the inner lead portions did not occur.

Further, the following evaluation tests with respect to this TAB tape were carried out.

(1) Linearity of wiring patterns

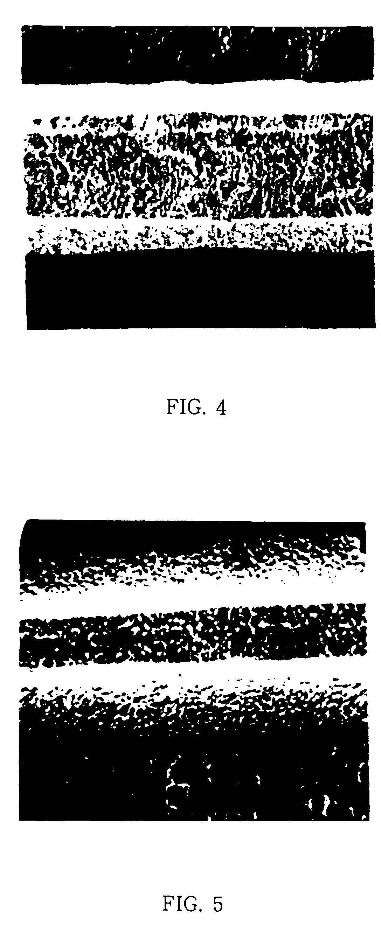

A circuits-formed TAB tape obtained in Example 1 was placed on a specimen carrier for an electron microscope to take a micrograph at 1000 x magnification by a SEM (S - 4100 produced by Hitachi, Ltd.), as shown in Fig. 4.

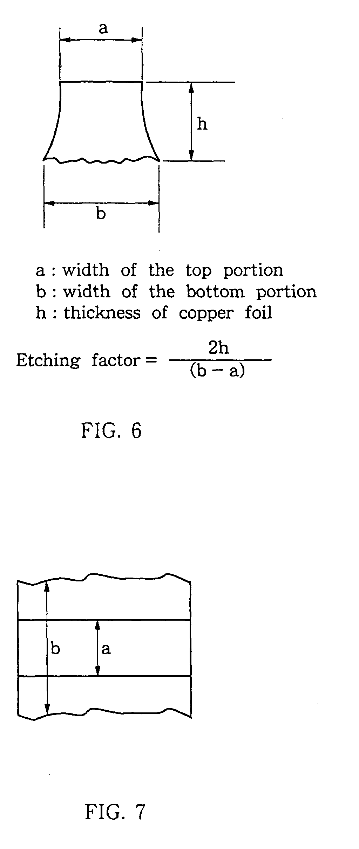

As shown in Fig. 7, the respective width lines of both top and bottom portions were drawn in parallel in the longitudinal direction of a circuit, and the respective widths thereof at 10 measuring points equally spaced by 10 $\mu$m were measured. After the measurement, the respective average values and standard deviations were calculated. The value of standard deviation is a guideline which exhibits the linearity of top and bottom portions. It is appreciated that a smaller value thereof exhibits a small deviation of width, that is, an etched portion is formed in a configuration with further straight lines, as shown in Fig. 1(a).

Thus obtained results are summarized in Table 3.

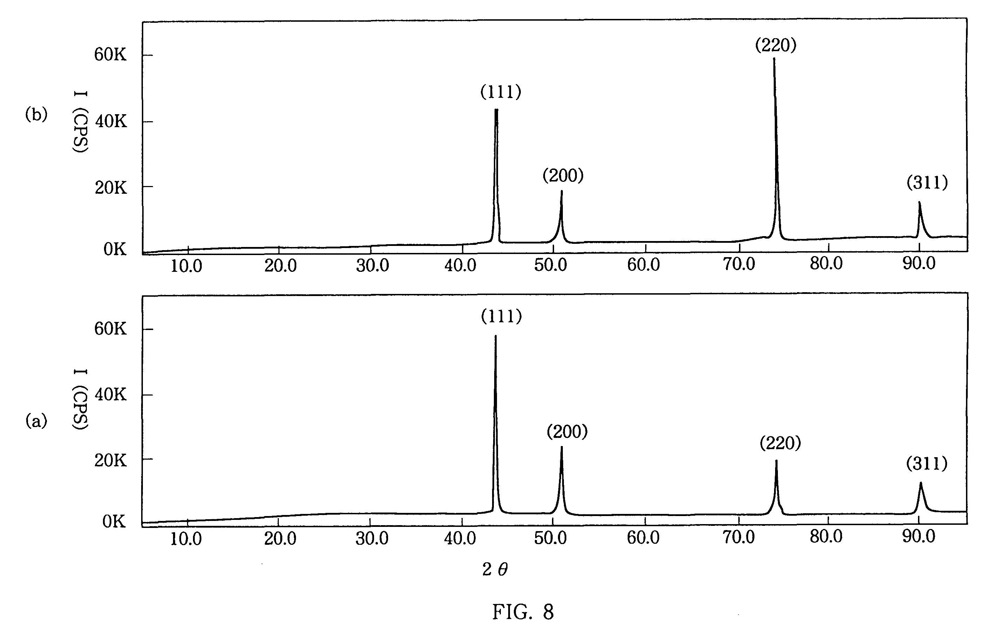

Further, the result of X-ray diffraction of the copper foil produced by a production process of the present invention is shown in Fig. 8(a). Since the orientation indexes obtained from the strength of peeks of X-ray diffraction by using Willson's formula are given as the following values, and therefore, it can be seen that copper crystals are oriented disorderly for the most part in the matte surface side of the electrodeposited copper foil obtained from Example 1 (Orientation index of disorder orientation corresponds to 1).

| Oriented face | (111) | (200) | (220) | (311) |
|---|---|---|---|---|
| Orientation index | 0.90 | 0.85 | 1.6 | 1.2 |

(2) Etching factors

Further, as shown in Fig. 6, based on measured values of Table 3, the widths of the top portion and bottom portion of a wiring pattern on a TAB tape are defined as a and b respectively, while defining the thickness thereof as h, and the etching factors (Ef) were obtained by the following expression.

$$Ef = 2h/(b-a) \; ; \; h = 18 \; \mu m$$

It can be found from this expression that the more squarish the section of a circuit is, that is, the more sharp it is, the etching factor becomes large. The average of 10 etching factors was 4.0.

Comparative Example 1

By using a copper foil having a thickness of 18$\mu$m, which has been developed as a use for a fine pitch circuit, a TAB tape was produced in the same manner as in Example 1. The copper foil was VLP produced by Mitsui Mining Smelting Co., Ltd. The surface roughness of a matte surface side of the copper foil was 3.8 $\mu$m, and the tensile strength of a copper foil after heating (after one hour oven heating at 180 $°$C) was 470 N/mm$^2$ (48.0 kgf/mm$^2$).

A scanning electron micrograph (SEM photograph) of the surface state of a matte surface side of the obtained electrodeposited copper foil is shown in Fig. 3. As apparent from the SEM photograph, projected portions or convex portions of the surface are larger than that of the copper foil obtained in Example 1, that is, the matte surface in this Comparative Example was extremely rough.

50 $\mu$m pitch fine pattern circuits were formed on the obtained TAB tape in the same manner as in Example 1, and both of the difference between the inwardly concave and outwardly convex bottom lines of a circuit pattern formed by an etching process and bending at the 50 $\mu$m pitch inner lead portions were evaluated. According to the results of this evaluation, A part of the inner lead portion was bent, the difference between the widths of the top and bottom portions was large, and the width of the top portion was significantly small, as compared with the width of the bottom portion. Further, the difference between the inwardly concave and outwardly convex bottom lines thereof was undesirably large. And, the surface state of a matte surface side of a copper foil was evaluated by the surface roughness $R_z$.

A micrograph at 1000 x magnification was taken by a SEM (S - 4100, produced by Hitachi, Ltd.) in just the same manner as in Example 1, as shown in Fig. 5. The respective average values and standard deviations of both top and bottom portions of a circuit were calculated, in the same manner as in Example 1. These obtained results are summarized in Table 3.

Further, the result of X-ray diffraction of the copper foil used in Comparative Example 1 is shown in Fig. 8(b). Since the orientation indexes obtained from the strength of peeks of X-ray diffraction by using Willson's formula in the same manner as in Example 1 are given as the following values, and therefore, it can be seen that copper crystals are preferentially orientated to the (220) plane in the matte surface side of the electrodeposited copper foil obtained from Comparative Example 1 (Orientation index).

| Oriented face | (111) | (200) | (220) | (311) |
|---|---|---|---|---|
| Orientation index | 0.58 | 0.56 | 3.9 | 1.2 |

## Table 3

| | Pattern section | | Etching factors | Lineality | | Roughness of the matte surface side Rz ($\mu$m) | Bending of Inner lead | Tensile strength at post-heating (Kgf/mm²) N/mm² |
|---|---|---|---|---|---|---|---|---|
| | Top value avarage a $\mu$m | Bottom value avarage b $\mu$m | | Bottom value standard deviation | Top value standard deviation | | | |
| Example 1 | 13.4 | 22.3 | 4.0 | 0.12 | 0.12 | 2.5 | non | (41.1) 403 |
| Comp. Example 1 | 6.5 | 24.4 | 2.0 | 1.16 | 1.16 | 3.8 | a little | (48.0) 470 |

EP 0 841 412 B1

Examples 2 to 5 and Comparative Examples 2 to 7

Electrodeposited copper foils were produced by using electrolytes having compositions described in Table 4. The current density was 40 to 65 A/dm$^2$ and the electrolyte temperature was 45 to 55 °C.

The tensile strength and elongation of thus obtained electrodeposited copper foils were evaluated at room temperature and after heating (after one hour oven heating at 180 °C). The results of the evaluation of some examples including Example 1 and Comparative Example 1 are described in Table 4. The surface state on a matte surface side of a copper foil was evaluated by the surface roughness $R_Z$.

# Table 4

| Example Comp. Example | Electrolyde Composition (g/l) | | | | | Physical properties of copper foil | | | | |
| | CuSO$_4$ 5H$_2$O | H$_2$SO$_4$ | Poly-ether | Tin ions | IRON ions | Room temperature | | Post-heating *1 | | Surface state |
| | | | | | | Tensile strength (Kgf/mm$^2$) N/mm$^2$ | Elongation (%) | Tensile strength (Kgf/mm$^2$) N/mm$^2$ | Elongation (%) | Roughness ($\mu$m) |
| Example 1 | 314 | 150 | 0.1 | 0.5 | 1.0 | (52.0) 510 | 4.5 | (41.1) 403 | 6.6 | 2.5 |
| Example 2 | 314 | 150 | 0.01 | 0.5 | 0.5 | (55.7) 546 | 4.8 | (40.5) 397 | 6.2 | 2.4 |
| Example 3 | 314 | 150 | 0.05 | 0.5 | 1.0 | (54.1) 530 | 4.5 | (40.8) 400 | 7.6 | 2.5 |
| Example 4 | 314 | 150 | 0.10 | 1.0 | 1.0 | (54.0) 529 | 4.5 | (48.8) 478 | 5.6 | 2.4 |
| Example 5 | 314 | 150 | 0.10 | 1.0 | 5.0 | (53.8) 527 | 4.7 | (48.5) 475 | 5.9 | 2.5 |
| Comp. Example 1 | VLP foil manufactured by Mitsui Mining and Smelting CO., Ltd | | | | | (52.0) 510 | 7.0 | (48.0) 470 | 6.0 | 3.8 |
| Comp. Example 2 | 314 | 150 | — | — | 1.0 | (64.6) 633 | 3.8 | (30.1) 295 | 13.8 | 2.1 |
| Comp. Example 3 | 314 | 150 | 0.01 | — | 1.0 | (71.2) 698 | 3.7 | (30.1) 295 | 15.5 | 2.0 |
| Comp. Example 4 | 314 | 150 | 0.05 | — | 1.0 | (70.2) 688 | 4.2 | (29.5) 289 | 15.0 | 2.1 |
| Comp. Example 5 | 314 | 150 | 0.10 | — | 1.0 | (70.1) 687 | 4.2 | (29.6) 290 | 16.2 | 2.0 |
| Comp. Example 6 | 314 | 150 | — | — | — | (53.0) 519 | 4.9 | (28.0) 274 | 15.0 | 4.5 |
| Comp. Example 7 | 314 | 150 | Cl$^-$1ppm | | | (46.3) 454 | 13.2 | — | — | 9.6 |

* 1:180°C, after one hour oven heating at 180°C

As described in Table 4, in Examples 2 to 5, the tensile strength and elongation of copper foils at room temperature and after heating are within preferable ranges, and the surface roughness R$_z$ is also preferably small. Particularly, copper foils obtained by Examples 4 and 5 after heating exhibited a high value in the tensile strength.

On the other hand, in the copper foil (Comparative Example 2) obtained by using an electrolyte which contains neither polyether nor tin ions, and in the copper foil (Comparative Examples 3 to 5) obtained by using an electrolyte which contains no tin ions, the tensile strength of copper foils at room temperature is high, and the surface roughness $R_Z$ is very small. However, the tensile strength of copper foils after heating is lower than the desirable range.

Further, in the copper foil (Comparative Example 6) obtained by using an electrolyte which only contains copper sulfate and sulfuric acid as an electrolyte, and in the copper foil (Comparative Example 7) obtained by using an electrolyte which contain sulfate, sulfuric acid and a desired amount of chlorine ions as an electrolyte, the surface roughness $R_Z$ of the matte surface of obtained copper foils is large, and the tensile strength of copper foils after heating is deteriorated.

Industrial Applicability

As explained above, in the electrodeposited copper foil produced by the process of the present invention, the difference between the inwardly concave and outwardly convex portions of bottom lines of a circuit pattern formed by an etching process can preferably be improved by allowing the crystalline particle diameter of a matte surface of the copper foil to fine or miniaturize, so as to reduce the surface roughness. Further, the etching factors can be increased by orientating disorderly the matte surface side of a copper foil. As a result, the difference between the widths of the top portion and the bottom portion of a circuit section is reduced, and the circuit has a large section modulus. Further, since the electrodeposited copper foil of the present invention has a high tensile strength after heating, deformation at the inner lead portions and the like does not occur.

Therefore, the electrodeposited copper foil obtained by the present invention is preferable as a copper foil for use in a TAB tape and the like in which fine pitch circuits are required.

**Claims**

1. A high tensile strength electrodeposited copper foil **characterized in that** said copper foil contains 50 to 1200 ppm of Sn and 1 to 50 ppm of Fe and that the surface roughness $R_Z$ of a matte surface side of said copper foil is not more than 2.5μm and the tensile strength thereof after one hour oven heating at 180°C is not less than (40 kgf/mm$^2$) 392 N/mm$^2$.

2. A high tensile strength electrodeposited copper foil according to claim 1, wherein copper crystals of the matte surface side of the copper foil are oriented disorderly to X-ray diffraction strength of peeks of (111), (200), (220) and (311) planes of the copper crystals.

3. A process for producing a high tensile strength electrodeposited copper foil comprising a step of electrolyzing with an electrolyte containing a copper sulfate and sulfuric acid as main components, and containing 0.01 to 0.10 g/l of a polyether, 0.5 to 1.0 g/l of tin ions, 0.5 to 5.0 g/l of iron ions and less than 0.1 mg/l of chlorine ions.

4. A TAB (Tape Automated Bonding) tape comprising a circuit produced by etching a copper foil according to claim 1.

**Patentansprüche**

1. Elektrobeschichtete Kupferfolie hoher Zugspannung, **dadurch gekennzeichnet, daß** die Kupferfolie 50 bis 1.200 ppm Sn und 1 bis 50 ppm Fe enthält, und daß die Oberflächenrauhigkeit $R_Z$ einer matten Oberflächenseite der Kupferfolie nicht mehr als 2,5 μm beträgt, und daß ihre Zugspannung nach einstündiger Erhitzung im Ofen bei 180°C nicht kleiner als 392 N/mm$^2$ (40 kgf/mm$^2$) ist.

2. Elektrobeschichtete Kupferfolie hoher Zugspannung nach Anspruch 1, wobei Kupferkristalle der matten Oberflächenseite der Kupferfolie ungeordnet nach Röntgendefraktion der Peekstärken von (111), (200), (220) und (311) Flächen der Kupferkristalle sind.

3. Verfahren zur Herstellung einer elektrobeschichteten Kupferfolie hoher Zugspannung, wobei in einer Stufe mit einem Elektrolyten elektrolysiert wird, der ein Kupfersulfat und Schwefelsäure als Hauptkompenten und 0,01 bis 0,10 g/l eines Polyethers, 0,5 bis 1,0 g/l Zinnionen, 0,5 bis 5,0 g/l Eisenionen und weniger als 0,1 mg/l Chlorionen enthält.

4.  Ein TAB (Tape Automated Bonding)-Band mit einer durch Ätzen einer Kupferfolie nach Anspruch 1 hergestellten Schaltung.

**Revendications**

1.  Feuille de cuivre déposé par voie galvanique, à résistance élevée à la traction, **caractérisée en ce que** ladite feuille de cuivre contient 50 à 1200 ppm de Sn et 1 à 50 ppm de Fe, **en ce que** la rugosité de surface $R_Z$ d'un côté de surface mat de ladite feuille de cuivre ne dépasse pas 2,5 $\mu$m et **en ce que** la résistance à la traction de celle-ci après chauffage au four pendant une heure à 180°C ne dépasse pas 392 N/mm$^2$ (40 kgp/mm$^2$).

2.  Feuille de cuivre déposé par voie galvanique, à résistance élevée à la traction selon- la revendication 1, dans laquelle des cristaux de cuivre du côté de surface mat de la feuille de cuivre sont orientés de façon désordonnée aux maxima des pics de diffraction des rayons X des plans (111), (200), (220) et (311) des cristaux de cuivre.

3.  Procédé de production d'une feuille de cuivre déposé par voie galvanique, à résistance élevée à la traction comprenant une étape d'électrolyse avec un électrolyte contenant du sulfate de cuivre et de l'acide sulfurique comme principaux composants, et contenant 0,01 à 0,10 g/l d'un polyéther, 0,5 à 1,0 g/l d'ions étain, 0,5 à 5,0 g/l d'ions fer et moins de 0,1 mg/l d'ions chlore.

4.  Bande TAB (soudage sur bande) comprenant un circuit produit en gravant une feuille de cuivre selon la revendication 1.

(a)

(b)

FIG. 1

FIG. 2

FIG. 3

FIG. 4

FIG. 5

a : width of the top portion
b : width of the bottom portion
h : thickness of copper foil

$$\text{Etching factor} = \frac{2h}{(b - a)}$$

FIG. 6

FIG. 7

FIG. 8

EP 0 841 412 B1